Europäisches Patentamt

European Patent Office

Office européen des brevets

(19)

(11) Veröffentlichungsnummer: **0 308 766 B1**

# (12) EUROPÄISCHE PATENTSCHRIFT

(45) Veröffentlichungstag der Patentschrift: 27.11.91

(51) Int. Cl.⁵: **H03K 17/945**

(21) Anmeldenummer: 88114897.7

(22) Anmeldetag: 12.09.88

(54) **Näherungsschalter mit einer Prüf- und Auswerteschaltung.**

(30) Priorität: 24.09.87 DE 3732211

(43) Veröffentlichungstag der Anmeldung:
**29.03.89 Patentblatt 89/13**

(45) Bekanntmachung des Hinweises auf die
Patenterteilung:
**27.11.91 Patentblatt 91/48**

(84) Benannte Vertragsstaaten:
**DE FR GB IT SE**

(56) Entgegenhaltungen:
EP-A- 0 035 225       EP-A- 0 060 992
DE-A- 2 939 250       DE-A- 3 440 027
DE-B- 1 513 058       DE-C- 3 150 212
DE-C- 3 342 710

(73) Patentinhaber: **SIEMENS AKTIENGESELL-
SCHAFT
Wittelsbacherplatz 2
W-8000 München 2(DE)**

(72) Erfinder: **Hamel, Manfred, Dipl.-Ing. (FH)
Rajen 237
W-2953 Rhauderfehn(DE)**

## Beschreibung

Die Erfindung bezieht sich auf einen Näherungsschalter mit einer Prüf- und Auswerteschaltung, mit einer Steuerschaltung zur Impulserzeugung, einem Oszillator, einem periodisch wirksam werdenden Bedämpfungskreis für den Oszillator und einer Relaisschaltung.

Eine Prüf- und Auswerteschaltung der vorgenannten Art ist aus der EP 0 060 992 bekannt. Hierin wird eine Prüf- und Auswerteschaltung für die einwandfreie Funktion eines als Element einer Maschinensteuerung vorgesehenen Näherungsschalters beschrieben, der zwischen seinen beiden Schaltzuständen mit Bedämpfung und ohne Bedämpfung mittels einer Steuerschaltung umsteuerbar ist. Hierdurch entsteht am Ausgang des Näherungsschalters ein getaktetes Ausgangssignal, das einem mit dem Näherungsschalter verbundenen Auswertekreis zugeführt ist. Solange ein getaktetes Ausgangssignal vorliegt, wird durch den Näherungsschalter über seine die Maschinensteuerung überwachende Relaisschaltung an diese ein Freigabesignal gegeben. Beim Ausbleiben des getakteten Ausgangssignals wird dagegen ein Sperrsignal für die Maschinensteuerung erzeugt. In der hier beschriebenen Steuerschaltung des Näherungsschalters wird ständig mittels eines astabilen Multivibrators ein Recktecksignal erzeugt. Bei Bedämpfung des Näherungsschalters durch ein äußeres Betätigungselement für längere Zeit ist ein thermischer Überlastschutz erforderlich, um elektronische Schaltglieder der Auswerteschaltung zu schützen. Außerdem wird im von außen bedämpften Zustand des Näherungsschalters seine Auswerteschaltung strommäßig belastet. Diese strommäßige Belastung betrifft vor allem die Schalttransistoren sowie die Primärseite des am Eingang der Relaisschaltung befindlichen Transformators. Die Relaisschaltung enthält zwei Relais, die nacheinander geschaltet werden und in unterschiedlichen Strompfaden liegen.

Aus der DE 33 42 710 ist ein induktiver Näherungsschalter mit einer HF-Oszillatorstufe, einer Schaltstufe, einer Verstärkerstufe und einer Endstufe bekannt. Die elektrische Energie wird über eine Auswerteeinheit dem Näherungsschalter an seinen beiden Anschlußpunkten zugeführt. Durch einen Brückengleichrichter, der zwischen den Anschlußpunkten und den Schaltungskomponenten eingefügt ist, kann der Näherungsschalter unabhängig von der versorgungsseitigen Polung des Signalstromkreises betrieben werden. Bei von außen bedämpftem Oszillator ist es möglich, durch Umpolung des Signalstromkreises eine Entdämpfung des Oszillators vorzunehmen, was bei einwandfreier Funktion der Schaltungskomponenten einen entsprechenden Signalwechsel am Ausgang des Näherungsschalters zur Folge hat. In gleicher Weise ist auch eine Funktionsprüfung bei von außen unbedämpftem Oszillator mittels Umpolung des Signalstromkreises durchführbar. Dies führt zu einer internen Bedämpfung des Oszillators. Zur Umschaltung zwischen dem Abfragebetrieb, der den aktuellen Normalzustand darstellt, und dem Prüfbetrieb sind bestimmte Forderungen an eine Versorgungs-, Auswerte- und Überwachungsschaltung zu stellen. Eine solche Schaltung muß die Versorgungsspannung bereitstellen; sie muß die periodische Umpolung der Versorgungsspannung gemäß einer Impulsfolge vornehmen. Diese zur Umschaltung dienende Impulsfolge wird jedoch von der Auswerte- und Überwachungsschaltung generiert.

Schließlich ist aus der DE 31 50 212 für einen induktiven Näherungsschalter eine Schaltungsanordnung bekannt, mit welcher unabhängig vom aktuellen Betriebszustand des Oszillators die Funktion des Näherungsschalters überprüft werden kann. Dieser weist einen Hochfrequenzoszillator, einen nachgeschalteten Verstärker und eine Prüfeinrichtung mit einem Prüfanschluß auf. Durch Ansteuerung des Prüfanschlusses mit einem über einen Drucktaster ausgelösten Prüfsignal kann der von außen ungedämpfte Oszillator gedämpft und der gedämpfte Oszillator entdämpft werden. Diese schaltungsintern mittels des Drucktasters verursachte Umkehrung des jeweils momentanen Oszillatorzustandes bewirkt eine Änderung des am Näherungsschalter anstehenden Ausgangssignals. Seine Auswertung gibt Aufschluß über die Verfügbarkeit des Näherungsschalters. Die Funktion des Drucktasters kann durch eine automatisch ansprechende Schaltungsstufe übernommen werden.

Der Erfindung liegt die Aufgabe zugrunde, eine gegenüber der oben genannten verbesserte Prüf- und Auswerteschaltung eines Näherungsschalters anzugeben, mit der der störungsfreie Betrieb des Näherungsschalters selbst und der Elemente der Prüf- und Auswerteschaltung überwacht wird, wobei die Zuverlässigkeit der Prüf- und Auswerteschaltung und damit auch die Verfügbarkeit des Näherungsschalters erhöht wird.

Diese Aufgabe wird bei der obengenannten Prüf- und Auswerteschaltung dadurch gelöst, daß die Prüfschaltung mit dem Bedämpfungskreis und mit der Steuerschaltung eine für die aktive Prüfung erforderliche Impulsfolge nur solange erzeugt, wie der Näherungsschalter durch ein äußeres Betätigungselement unbedämpft ist und daß die Auswerteschaltung nur solange einen Ansprechstrom führt, wie auch die Prüfschaltung in ihrem fehlerlosen Zustand aktiv prüft und daß die Steuerschaltung aus einem auf die Schwingungsamplitude des Oszillators ansprechenden integrierten Schaltkreis und aus einer mit einem seiner Ausgänge verbundenen Monoflopschaltung besteht, die zwei in Reihe geschaltete Monoflops enthält, wobei der integrierte Schaltkreis eingangsseitig am Oszillator angeschlossen ist und sich zwischen diesem und dem Ausgang der Monoflopschaltung der Bedämpfungskreis befindet und wobei die Auswerteschaltung über ein Netzwerk an die Verbindung zwischen dem integrierten Schaltkreis und der Monoflopschaltung angeschlossen ist. Eine derartige Steuerschaltung zeichnet sich durch einfache und leicht verfügbare Schaltungskomponenten aus. Weiterhin erweist es sich als günstig, daß die Steuerschaltung eine Impulsfolge am Ausgang des integrierten Schaltkreises erzeugt, die das Netzwerk in entsprechende Zustandswechsel für die Auswerteschaltung umwandelt. Die Impulsfolge wird mit Hilfe des zum Näherungsschalter zugehörigen integrierten Schaltkreises in einem geschlossenen Wirkungskreis gebildet, zu dem noch die Monoflopschaltung, der Bedämpfungskreis sowie der Oszillator gehören. Hieraus ergibt sich eine Selbstüberwachung dieser Komponenten, da diese nur in fehlerlosem Zustand die Erzeugung der Impulsfolge ermöglichen. Die Schaltung kann im Gegensatz zur üblichen Anwendung auch mit inverser Logik betrieben werden; das bedeutet, bei der vorliegenden Schaltung besteht die Möglichkeit, bei Anwesenheit eines Betätigungselementes die Impulsfolge zu erzeugen. In diesem Fall wird der Oszillator mit kleiner Schwingungsamplitude betrieben, die erst bei Annäherung eines Betätigungselementes aus einem ferromagnetischen Stoff auf einen zur Impulserzeugung benötigten Wert am Eingang des integrierten Schaltkreises vergrößert wird.

Die Auswerteschaltung weist zwei Anschlüsse auf, die mit zwei Ausgängen des Netzwerkes der Prüfschaltung verbunden sind, wobei der erste Anschluß E mit einer Bürde und der zweite Anschluß mit dem Minuspol einer Gleichspannung verbunden ist, die durch ein Netzteil erzeugt wird und die die Auswerteschaltung versorgt. An der Bürde wird mittels der Gleichspannung der Zustandswechsel am Ausgang des Netzwerkes in eine für die Auswertung günstige Rechteckspannung umgeformt. Der Bürde ist in der angeführten Reihenfolge ein Schmitt-Trigger, eine Schutzschaltung gegen Kurzschluß, eine Verstärkerschaltung, ein Transformator und eine Relaisschaltung nachgeschaltet, wobei letztere über einen Ausgang der Auswerteschaltung mit einem vom Näherungsschalter zu steuernden Lastkreis verbunden ist. Der Vorteil der Schaltung besteht im Aufbau mit einfachen und sicheren Schaltungsteilen. Der Schmitt-Trigger bildet auch aus einem verschliffenen Signal einen genau definierten Spannungspegel an seinem Ausgang, was sich für den sicheren und störungsfreien Betrieb der nachfolgenden Schaltungsteile als günstig erweist. Ist aber das Signal aufgrund eines Fehlers in einem dem Schmitt-Trigger vorgeschalteten Schaltungsteil stark verzerrt, so spricht der Schmitt-Trigger nicht an und bewirkt somit den Übergang des Näherungsschalters in den sicheren Zustand.

Die Relaisschaltung weist eine Gleichrichter-Brückenschaltung mit einem Plus- und einem Minuspol auf, die eingangsseitig mit der Sekundärseite des Transformators verbunden ist und an der ausgangsseitig zwischen ihrem Plus- und Minuspol ein Glättungskondensator liegt, dem eine Reihenschaltung, bestehend aus einem Kondensator, einem ersten ohmschen Widerstand sowie zwei Öffnerkontakten zweier zwangsgeführter Relais die auch zwei Schließerkontakte aufweisen, parallel geschaltet ist, wobei zu dem Kondensator ein zweiter ohmscher Widerstand sowie eine Reihenschaltung aus einer Zenerdiode und einem dritten ohmschen Widerstand parallel liegen, wobei die Kathode der Zenerdiode mit dem Pluspol verbunden ist und der Verbindungspunkt zwischen der Zenerdiode und dem dritten ohmschen Widerstand mit der Steuerelektrode eines Thyristors verbunden ist, dessen Kathode ebenso wie der dritte ohmsche Widerstand mit dem vom Pluspol abgewandten Anschluß des Kondensators verbunden ist und zwischen dem Pluspol und der Anode des Thyristors die beiden Relais in Reihe geschaltet sind, zu denen parallel eine Diode liegt, die kathodenseitig mit dem Pluspol verbunden ist, wobei zwischen ihrer Anode und dem Minuspol die beiden in Reihe geschalteten Schließerkontakte liegen. Zwei weitere durch die Relais geschaltete Schließerkontakte liegen in dem Lastkreis. Die Relaisschaltung ist Bestandteil der verbesserten Auswerteschaltung und besitzt folgende Vorteile: Die beiden zwangsgeführten Relais überwachen sich selbst. Für den Fall, daß der Arbeitskontakt eines der beiden Relais im stromlosen Zustand geschlossen bleibt, ist das nachfolgende Ansprechen des anderen Relais auch durch einen zusätzlichen Fehler in der Relaisschaltung, wie zum Beispiel das Durchlegieren des Thyristors, ausgeschlossen. Durch die beschriebene Relaisschaltung ist außerdem für ein sicheres Ansprechen der Relais gesorgt, das über die gespeicherte Energie des in der Reihenschaltung befindlichen Kondensators erfolgt und das erst durch Zündung des Thyristors bei ausreichend hoher Spannung an diesem Kondensator eingeleitet wird.

Im folgenden wird die Erfindung anhand einer ein Ausführungsbeispiel darstellenden Zeichnung ausführlich erläutert.

Es zeigen:

FIG 1    ein Blockschaltbild eines Näherungsschalters mit Prüf- und Auswerteschaltung,

FIG 2    die Signale an verschiedenen Punkten der Auswerteschaltung,

FIG 3    die detaillierte Auswerteschaltung.

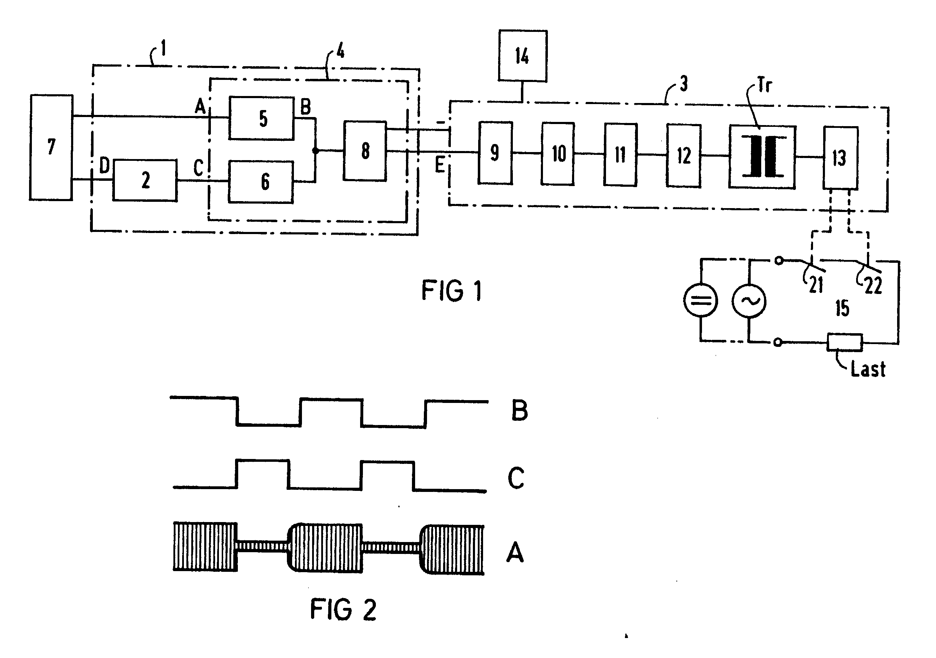

Die Figur 1 zeigt einen zu einem induktiven Näherungsschalter zugehörigen Oszillator 7, der mit zwei Anschlüssen versehen ist, die mit einer Prüfschaltung 1 verbunden sind, welche eine Steuerschaltung 4 mit einem Eingang A und dazu in Reihe einen Bedämpfungskreis 2 mit einem Ausgang D enthält. Der eine Anschluß des Oszillators 7 ist an den Eingang A der Steuerschaltung 4 angeschlossen, und der andere Anschluß ist mit dem Ausgang D des Bedämpfungskreises 2 verbunden. Die Steuerschaltung 4 besteht aus einem integrierten Schaltkreis 5, der als Eingang den Eingang A besitzt und der einen Ausgang B aufweist, an welchen eine Monoflopschaltung 6 sowie ein Netzwerk 8 angeschlossen sind. Die Monoflopschaltung 6, bestehend aus zwei in Reihe geschalteten Monoflops, besitzt einen Ausgang C, der zugleich ein Ausgang der Steuerschaltung 4 ist und mit dem der Bedämpfungskreis 2 verbunden ist. Das Netzwerk 8 hat neben seinem Anschluß an den Ausgang B des integrierten Schaltkreises 5 zwei Ausgänge, die zugleich als Ausgänge der Steuerschaltung 4 und der Prüfschaltung 1 dienen und die mit zwei Eingängen einer Auswerteschaltung 3 verbunden sind. In der Auswerteschaltung 3 befindet sich eine Reihenschaltung, bestehend aus einer Bürde 9, einem Schmitt-Trigger 10, einer Schutzschaltung 11, einer Verstärkerschaltung 12, einem Transformator Tr und einer Relaisschaltung 13 mit zwei Relais K1, K2, wobei die Komponenten in der genannten Reihenfolge miteinander verschaltet sind. Die Bürde 9 ist mit dem ersten Eingang E der Auswerteschaltung verbunden, deren zweiter Eingang an den Minuspol einer Gleichspannung angeschlossen ist, die von einem Netzteil 14 erzeugt wird und die Auswerteschaltung 3 versorgt. Die Auswerteschaltung 3 ist über zwei Schließerkontakte 21, 22 der beiden Relais K1, K2 der Relaisschaltung 13 mit einem Lastkreis 15 verbunden.

Der Oszillator 7 schwingt in ungedämpftem Zustand auf eine am Eingang A des integrierten Schaltkreises 5 anstehende Amplitude an, die gegenüber dem gedämpften Zustand bei von außen genähertem Betätigungselement größer ist und infolgedessen einen Zustandswechsel am Ausgang B des integrierten Schaltkreises 5 zur Folge hat. Der an die Monoflopschaltung 6 weitergeleitete Zustandswechsel bewirkt, daß diese über ihren Ausgang C nach einer bestimmten Zeitdauer nach Eintritt des Zustandswechsels ein Signal an den Bedämpfungskreis 2 weitergibt, der daraufhin momentan den Oszillator 7 für eine festgelegte Zeitdauer bedämpft. Durch den Übergang in den bedämpften Zustand des Oszillators 7, bei dem die Oszillator-Amplitude klein ist, wechselt der Ausgang B wiederum seinen Zustand. Erst nach Ablauf der durch die Monoflopschaltung 6 vorgegebenen Bedämpfungsdauer wird die Bedämpfung durch den Bedämpfungskreis 2 aufgehoben, und der Oszillator 7 schwingt wieder ungedämpft an, womit der zuvor beschriebene Zyklus von neuem sich wiederholt. Die durch die Monoflopschaltung 6 vorgegebene Bedämpfungsdauer ist so auf die Zeitdauer des Anschwingens des Oszillatos abgestimmt, daß sich am Ausgang B des integrierten Schaltkreises 5 eine periodische Signalfolge gemäß FIG 2 ergibt. Diese wird an ein Netzwerk 8 weitergeleitet, an dessen Ausgang zur Auswerteschaltung 3 daraufhin ein periodischer Zustandswechsel ansteht, der an der Bürde 9 eine entsprechende Rechteckspannung bewirkt. Der nachgeschaltete Schmitt-Trigger 10 erzeugt selbst aus einem verschliffenen, eingangsseitig anstehenden Rechtecksignal eine Rechteckspannung definierter Pegelhöhe, die in der anschließenden Verstärkerschaltung 12 verstärkt und danach dem Transformator Tr zugeführt wird. Die in diesem Fall auch auf der Sekundärseite des Transformators Tr anliegende Wechselspannung versorgt und steuert zugleich die Relaisschaltung 13, deren Relais K1, K2 anziehen. Zwischen dem Schmitt-Trigger 10 und der Verstärkerschaltung 12 liegt die Schutzschaltung 11. Sie schützt die Bürde 9 vor Überlastung bei einem Kurzschluß zwischen den Eingangsklemmen der Auswerteschaltung 3.

Die Wechselspannung an der Sekundärseite des Transformators Tr tritt nur in fehlerlosem Zustand der Prüf- 1 und Auswerteschaltung 3 während der Prüfdauer auf, in der der Näherungsschalter nicht bedämpft ist. Ein Ausbleiben dieser Wechselspannung während des unbedämpften Zustands weist auf einen Fehler innerhalb der Prüf- 1 und Auswerteschaltung 3 hin. Hierbei wechselt der Näherungsschalter in den sicheren Zustand, bei dem der zu steuernde Lastkreis 15 geöffnet ist.

Im Gegensatz zu dem zuvor beschriebenen unbedämpften Zustand schwingt im bedämpften Zustand des Näherungsschalters der Oszillator 7 nicht so hoch an und bewirkt infolgedessen auch keinen Zustandswechsel am Ausgang B des integrierten Schaltkreises 5. Stattdessen befindet sich der Ausgang B während der Bedämpfungsdauer in einem bestimmten, konstanten Zustand, bei dem in der Auswerteschaltung 3 kein Recktecksignal gebildet wird. In diesem Fall fließt in der Auswerteschaltung 3 kein Ansprechstrom, sondern nur ein geringer Ruhestrom. Das Fehlen der Rechteckspannung in der Auswerteschaltung 3 während der Bedämpfungsdauer bedeutet, daß die Relaisschaltung 13 nicht anspricht und daher der Lastkreis 15 ebenso im sicheren Zustand ist wie bei Vorliegen eines Fehlers.

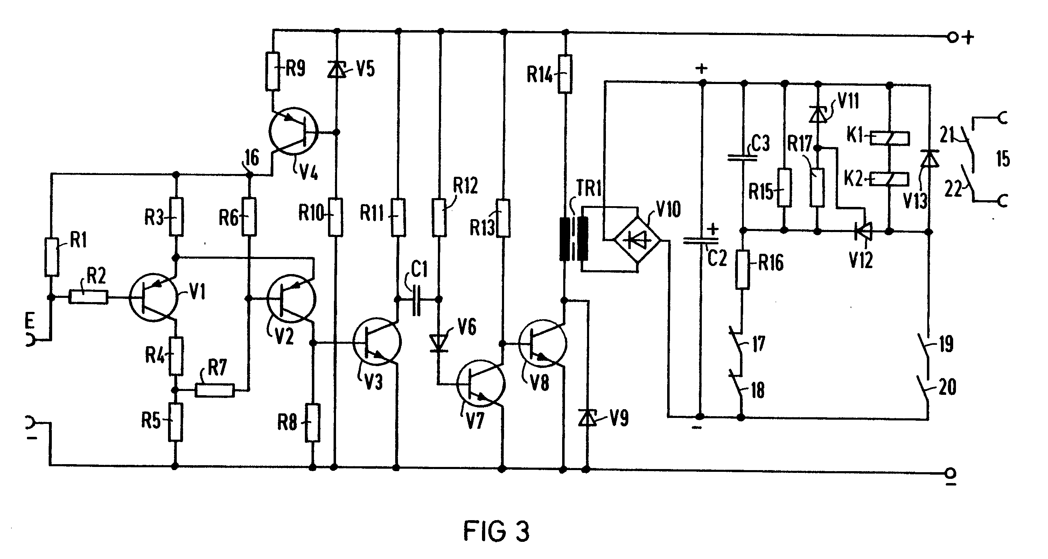

FIG 3 zeigt die detaillierte Auswerteschaltung 3 mit dem ersten Eingang E, an den die Bürde 9, bestehend aus dem ohmschen Widerstand R1, angeschlossen ist und mit dem zweiten Eingang, der mit dem Minuspol einer die Auswerteschaltung 3 versorgenden Gleichspannung verbunden ist. Die Gleichspannung wird durch das Netzteil 14 erzeugt. Der Bürde schließt sich der Schmitt-Trigger 10 an, der zwei Transistoren V1, V2 und acht ohmsche Widerstände R1 bis R8 aufweist. Beide Transistoren V1, V2 sind in Emitterschaltung geschaltet und über ihre Emitteranschlüsse miteinander verbunden, die wiederum über den Widerstand R3 an den Verbindungspunkt 16 angeschlossen sind. An den Eingang E sind die Widerstände R1 und R2 angeschlossen, wobei der Widerstand R1 mit seinem anderen Anschluß am Verbindungspunkt 16 liegt und der Widerstand R2 mit der Basis des Transistors V1 verbunden ist. Der Widerstand R6 liegt zwischen dem Verbindungspunkt 16 und der Basis des Transistors V2, an der außerdem der Widerstand R7 angeschlossen ist. Zwischen dem Kollektor des Transistors V1 und dem Minuspol liegen die in Reihe geschalteten Widerstände R4 und R5, wobei ihr Verbindungspunkt mit dem Widerstand R7 verbunden ist. Der Widerstand R8 liegt zwischen dem Kollektor des Transistors V2 und dem Minuspol der Gleichspannung. Die nachfolgende Schutzschaltung 11 besteht aus einem Transistor V4 und einer Zenerdiode V5 sowie zwei ohmschen Widerständen R9 und R10. Der Kollektor des Transistors V4 ist an dem Verbindungspunkt 16 angeschlossen. Zwischen der Basis des Transistors V4 und dem Minuspol liegt der Widerstand R10. Außerdem ist an der Basis des Transistors V4 die Zenerdiode V5 angeschlossen. Die beiden anderen Anschlüsse des Widerstands R9 und der Zenerdiode V5 sind im Pluspol der die Auswerteschaltung versorgenden Gleichspannung durch das Netzteil 14 vereinigt. Die folgende Verstärkerschaltung 12 setzt sich aus drei Transistoren V3, V7, V8 sowie einer Diode V6, einer Zenerdiode V9, einem Kondensator C1 und vier ohmschen Widerständen R11, R12, R13, R14 zusammen. Die Basis des Transistors V3 ist mit dem Kollektor des Transistors V2 verbunden, während der Emitter des Transistors V3 und auch die Emitteranschlüsse der Transistoren V7 und V8 direkt an den Minuspol der Gleichspannung angeschlossen sind. Die Widerstände R11, R12, R13 und R14 sind mit dem Pluspol der Gleichspannung verbunden. Der Kollektor des Transistors V3 ist mit dem Widerstand R11 und dem einen Anschluß des Kondensators C1 verschaltet. Der Widerstand R12 ist über die Diode V6 mit der Basis des Transistors V7 verbunden und der Kollektor des Transistors V7 ist sowohl an den Widerstand R13 als auch an der Basis des Transistors V8 angeschlossen. Der andere Anschluß des Kondensators C1 ist mit dem Verbindungspunkt zwischen dem Widerstand R12 und der Diode V6 verbunden. Die Primärwicklung vom nachgeschalteten Transformator Tr liegt zwischen dem Kollektor des Transistors V8 und dem einen Anschluß des Widerstands R14, dessen anderer Anschluß am Pluspol der Gleichspannung liegt. Die Zenerdiode V9 liegt zwischen dem Kollektor des Transistors V8 und dem Minuspol der Gleichspannung.

Die zwischen dem Eingang E der Auswerteschaltung 3 und dem Minuspol der Gleichspannung anstehende Rechteckschwingung wird von dem Schmitt-Trigger 10 auf ihren Pegel detektiert. Selbst aus einer verschliffenen Rechteckschwingung wird ein in seiner Pegelhöhe genau definiertes Rechtecksignal erzeugt, welches am Kollektor des Transistors V2 ansteht und von dort der Verstärkerschaltung 12 zugeführt wird. Die zwischengeschaltete Schutzschaltung 11 dient als Überlastungs- bzw. Kurzschlußschutz. Sie verhindert eine Überlastung des Widerstands R1 bei einem Klemmenkurzschluß zwischen dem Eingang E und dem Minuspol der Gleichspannung, da hierbei die Spannung an dem Widerstand R9 ansteigt und demzufolge der Transistor V4 die Stromaufnahme des Widerstandes R1 der Bürde 9 begrenzt. Bei dem betrachteten Kurzschluß wechselt der Näherungsschalter in den sicheren Zustand.

Mit dem Transistor V3 wird der vom Schmitt-Trigger 10 detektierte Pegel auf den Minuspegel umgesetzt. Der Kondensator C1 koppelt das Rechtecksignal aus und leitet es an die folgenden Verstärkerstufen mit den Transistoren V7 und V8 weiter. Durch den Kondensator C1 wird eine Entkopplung zwischen den Transistoren V8 und V2 vorgenommen, die als Schutz des Transistors V8 dient. Durch die Entkopplung mit dem Kondensator C1 wird ein dauerhaftes Durchschalten des Transistors V8 bei einem Fehler in einem vorgeschalteten Schaltungsteil verhindert. Diese Maßnahme ist erforderlich, um einen ständigen Stromfluß durch den Transistor V8 zu vermeiden, der ihn zerstören würde. Die Relaisschaltung 13 besteht aus einer Gleichrichter-Brückenschaltung V10 mit einem Plus- und einem Minuspol, einer Zenerdiode V11 und einer Diode V13, zwei Relais K1, K2 mit zwangsgeführten Kontakten, von denen jeweils einer als Öffnerkontakt 17, 18 und zwei als Schließerkontakte 19, 20, 21, 22 ausgebildet sind. Weiterhin gehören zur Relaisschaltung 13 ein Glättungskondensator C2 und ein Kondensator C3, drei ohmsche Widerstände R15, R16, R17 sowie ein Thyristor V12. Die Gleichrichter-Brückenschaltung V10 liegt eingangsseitig an der Sekundärseite des vorgeschalteten Transformators Tr und ist ausgangsseitig zwischen ihrem Plus- und Minuspol mit dem Glättungskondensator C2 verbunden. Parallel zum Glättungskondensator C2 ist eine Reihenschaltung, bestehend aus dem Kondensator C3, dem Widerstand R16 und den beiden Öffnerkontakten 17, 18 der beiden Relais K1, K2 angeschlossen. Parallel zum Kondensator C3 liegen der Widerstand R15 sowie die aus der Zenerdiode V11 und dem Widerstand R17 gebildete Reihenschaltung, wobei die Kathode der Zenerdiode V11 ebenso mit dem Pluspol der Gleichrichter-Brückenschaltung V10 verbunden ist wie der eine Anschluß des Kondensators C3. Der andere Anschluß des Widerstands R17 ist mit dem anderen Anschluß des Kondensators C3 verbunden, an dem auch die Kathode des Thyristors V12 angeschlossen ist. Die Basis des Thyristors V12 ist mit dem Verbindungspunkt zwischen der Zenerdiode V11 und dem Widerstand R17 verbunden. Die beiden in Reihe geschalteten Spulen der Relais K1, K2 sowie die Diode 13 liegen zwischen der Anode des Thyristors V12 und dem Pluspol der Gleichrichter-Brückenschaltung V10, an dem die Diode V13 mit ihrer Kathode angeschlossen ist. Zwischen ihrer Anode und dem Minuspol der Gleichrichter-Brückenschaltung V10 sind die beiden Schließerkontakte 19, 20 angeschlossen. Die beiden weiteren Schließerkontakte 21, 22 der Relais K1, K2 sind im Lastkreis 15 angeschlossen.

Im fehlerlosen Zustand der Prüf- 1 und Auswerteschaltung 3 steht während der Nichtbedämpfung des Näherungsschalters am Transformator Tr, eine Wechselspannung an, die von der Gleichrichterschaltung V10 gleichgerichtet und vom parallel liegenden Glättungskondensator C2 geglättet wird. Mit der Aufladung des Glättungskondensators C2 fließt auch über die Öffnerkontakte 17, 18 ein Strom, wodurch zugleich der Kondensator C3 aufgeladen wird. Sobald die Spannung am Kondensator C3 die Knickspannung der Zenerdiode V11 erreicht, entsteht über dem Widerstand R17 ein Spannungsfall, bei dem der Thyristor V12 zündet. Durch das folgende Entladen des Kondensators C3 über die Spulen der Relais K1, K2 ziehen die Relais K1, K2 an und gehen über die Schliesserkontakte 19, 20 in Selbsthaltung. Durch das Schließen der Kontakte 19, 20 wird der Thyristor V12 umgepolt und sperrt.

Die beiden Relais K1, K2 sind mit zwangsgeführten Kontakten ausgeführt. Dies hat zur Folge, daß ein Relais den Näherungsschalter auch für den Fall in den sicheren Zustand überführt, in dem die Relaiskontakte des anderen Relais kleben; denn ein neuerlicher Anzug des nicht klebenden Relais ist durch die Verriegelung mit dem zugehörigen Verriegelungs-Öffnerkontakt 17 oder 18 eines der beiden Relais K1, K2 ausgeschlossen. Bleibt z.B. einer der Schließerkontakte der beiden Relais kleben, so fällt nur eines der beiden Relais K1 oder K2 ab. Der Schließerkontakt 19 oder 20 eines der beiden Relais K1, K2 bleibt geschlossen, während der zugehörige Öffnerkontakt 17 oder 18 des nicht klebenden Relais K1 oder K2 geöffnet bleibt. Infolgedessen ist eine Aufladung des Kondensators C3 über den Widerstand R16 und die beiden Öffnerkontakte 17, 18 nicht möglich, selbst wenn eine Rechteckschwingung während des folgenden Prüfvorganges anliegt. Dies bedeutet, daß der Näherungsschalter dauerhaft in diesem Zustand bleibt. Die Relaisschaltung 13 ist auch gegenüber einem Kurzschluß über den Thyristor V12 oder einem Durchlegieren desselben gesichert. In diesem Fall erfolgt ein Stromfluß über die beiden Relais und den in Reihe geschalteten Widerstand R16, an dem allerdings eine so hohe Spannung abfällt, daß die Relais K1, K2 nicht mehr anziehen können. Hierbei ist die zuvor beschriebene Anwurfschaltung mit der Ansteuerung des Thyristors V12 unwirksam.

**Patentansprüche**

1. Näherungsschalter mit einer Prüf- (1) und Auswerteschaltung (3), mit einer Steuerschaltung (4) zur Impulserzeugung, einem Oszillator (7), einem periodisch wirksam werdenden Bedämpfungskreis (2) für den Oszillator (7) und einer Relaisschaltung (13), **dadurch gekennzeichnet,** daß die Prüfschaltung (1) mit dem Bedämpfungskreis (2) und mit der Steuerschaltung (4) eine für die aktive Prüfung erforderliche Impulsfolge nur solange erzeugt, wie der Näherungsschalter unbedämpft ist und daß die Auswerteschaltung (3) nur solange einen Ansprechstrom führt, wie auch die Prüfschaltung (1) in ihrem fehlerlosen Zustand aktiv prüft, und daß die Steuerschaltung (4) aus einem auf die Schwingungsamplitude des Oszillators (7) ansprechenden integrierten Schaltkreis (5) und aus einer mit einem seiner Ausgänge (B) verbundenen Monoflopschaltung (6) besteht, die zwei in Reihe geschaltete Monoflops enthält, wobei der integrierte Schaltkreis (5) eingangsseitig am Oszillator (7) angeschlossen ist und sich zwischen diesem und dem Ausgang der Monoflopschaltung (6) der Bedämpfungskreis (2) befindet und wobei die Auswerteschaltung (3) über ein Netzwerk (8) an die Verbindung zwischen dem integrierten Schaltkreis (5) und der Monoflopschaltung (6) angeschlossen ist.

2. Näherungsschalter nach Anspruch 1, **dadurch gekennzeichnet,** daß die Auswerteschaltung (3) zwei Anschlüsse aufweist, die mit zwei Ausgängen des Netzwerkes (8) der Prüfschaltung (1) verbunden sind, wobei der erste Anschluß E mit einer Bürde (9) und der zweite Anschluß mit dem Minuspol einer Gleichspannung verbunden ist, die durch ein Netzteil (14) erzeugt wird und die die Auswerteschaltung (3) versorgt.

3. Näherungsschalter nach Anspruch 2, **dadurch gekennzeichnet,** daß der Bürde (9) in der angeführten Reihenfolge ein Schmitt-Trigger (10) eine Schutzschaltung (11) gegen Kurzschluß, eine Verstärkerschaltung (12), ein Transformator (Tr) und die Relaisschaltung (13) nachgeschaltet ist, wobei letztere über einen Ausgang der Auswerteschaltung mit einem vom Näherungsschalter zu steuernden Lastkreis (15) verbunden ist.

4. Näherungsschalter nach Anspruch 3, **dadurch gekennzeichnet,** daß die Relaisschaltung (13) eine Gleichrichter-Brückenschaltung (V10) mit einem Plus- und einem Minuspol aufweist, die eingangsseitig mit der Sekundärseite des Transformators (Tr) verbunden ist und an der ausgangsseitig zwischen ihrem Plus- und Minuspol ein Glättungskondensator (C2) liegt, dem eine Reihenschaltung, bestehend aus einem Kondensator (C3), einem ersten ohmschen Widerstand (R16) sowie zwei Öffnerkontakten (17, 18) zweier zwangsgeführter Relais (K1, K2) die auch zwei Schließerkontakte (19, 20) aufweisen parallel geschaltet ist, wobei zu dem Kondensator (C3) ein zweiter ohmscher Widerstand (R15) sowie eine Reihenschaltung aus einer Zenerdiode (V11) und einem dritten ohmschen Widerstand (R17) parallel liegen, wobei die Kathode der Zenerdiode (V11) mit dem Pluspol verbunden ist und der Verbindungspunkt zwischen der Zenerdiode (V11) und dem dritten ohmschen Widerstand (R17) mit der Steuerelektrode eines Thyristors (V12) verbunden ist, dessen Kathode ebenso wie der dritte ohmsche Widerstand (R17) mit dem vom Pluspol abgewandten Anschluß des Kondensators (C3) verbunden ist und zwischen dem Pluspol und der Anode des Thyristors (V12) die beiden Relais (K1, K2) in Reihe geschaltet sind, zu denen parallel eine Diode (V13) liegt, die kathodenseitig mit dem Pluspol verbunden ist, wobei zwischen ihrer Anode und dem Minuspol die beiden in Reihe geschaltete Schließerkontakte (19, 20) liegen und zwei weitere durch die Relais (K1, K2) geschaltete Schließerkontakte (21, 22) in dem Lastkreis (15) liegen.

**Claims**

1. A proximity switch having a test (1) and evaluation circuit (3), with a control circuit (4) for generating pulses, an oscillator (7), a periodically activated damping circuit (2) for the oscillator (7) and a relay circuit (13), characterised in that the test circuit (1) with the damping circuit (2) and with the control circuit (4) generates a series of pulses required for active examination only as long as the proximity switch is not damped, and in that the evaluation circuit (3) only conducts a response current, as long as the test circuit (1) also actively examines in its faultless condition, and in that the control circuit (4) consists of an integrated switch circuit (5), responding to the oscillation amplitude of the oscillator (7), and of a monostable flip-flop circuit (6), connected to one of its outputs (B), which contains two monostable flip-flop connected in series, wherein the integrated switch circuit (5) is connected on the input side to the oscillator (7), and which circuit is located between this and the output of the monostable flip-flop circuit (6) of the damping circuit (2) and wherein the evaluation circuit (3) is connected via a network (8) to the connection between the integrated switch circuit (5) and the monostable flip-flop circuit (6).

2. A proximity switch according to claim 1, characterised in that the evaluation circuit (3) has two terminals, which are connected to two outputs of the network (8) of the test circuit (1), wherein the first terminal E is connected to a load (9) and the second terminal to the negative pole of a direct-current voltage, which is generated by a network (14) and which supplies the evaluation circuit (3).

3. A proximity switch according to claim 2, characterised in that the load (9) has connected after it in the quoted sequence a Schmitt-trigger (10), a protective circuit (11) against short circuiting, an amplifier circuit (12), a transformer (Tr), and the relay circuit (13), wherein the latter is connected by way of an output of the evaluation circuit to a load circuit (15) to be controlled by the proximity switch.

4. A proximity switch according to claim 3, characterised in that the relay circuit (13) has a direct-current bridge circuit (V10) with a positive and a negative pole, which is connected on the input side to the secondary side of the transformer (Tr), and on the output side between its positive and negative pole there lies a smoothing capacitor (C2), to which is connected in parallel a series connection, consisting of a capacitor (C3), a first ohmic resistor (R16) as well as two break contacts (17, 18) of two positively-driven relays (K1, K2), which also have two make contacts (19, 20), wherein lying parallel to the capacitor (C3) there is a second ohmic resistor (R15) as well as a series connection of a Zener diode (V11) and a third ohmic resistor (R17), wherein the cathode of the Zener diode (V11) is connected to the positive pole, and the connecting point between the Zener diode (V11) and the third ohmic resistor (R17), is connected to the control electrode of a thyristor (V12), the cathode of which, like the third ohmic resistor (R17) is connected to the terminal of the capacitor (C3), facing away from the positive pole, and between the positive pole and the anode of the thyristor (V12) both relays (K1, K2) are connected in series, and lying parallel to these there is a diode (V13), which is connected to the positive pole on the cathode side, wherein lying between its anode and the negative pole there are both make contacts (19, 20) connected in series, and two further make contacts (21, 22) connected by the relays (K1, K2) lie in the load circuit (15).

**Revendications**

1. Interrupteur de proximité comportant un circuit de contrôle (1) et un circuit d'évaluation (3), un circuit de commande (4) servant à produire des impulsions, un oscillateur (7), un circuit amortisseur (2) qui devient actif périodiquement pour l'oscillateur (7) et un circuit de relais (13), caractérisé par le fait que le circuit de contrôle (1) pourvu du circuit amortisseur (2) et du circuit de commande (4) produit une suite d'impulsions nécessaire pour le contrôle actif, uniquement tant que l'interrupteur de proximité est non amorti, et que le circuit d'évaluation (3) envoie un courant de réponse tant que le circuit de contrôle (1) effectue également un contrôle actif dans son état sans défaut, et que le circuit de commande (4) est constitué par un circuit intégré (5) qui répond à l'amplitude d'oscillation de l'oscillateur (7), et par un circuit à multivibrateur monostable (6), qui est raccordé à l'une des sorties (B) des circuits (5) et contient deux multivibrateurs monostables branchés en série, que le circuit intégré (5) est raccordé par son entrée à l'oscillateur (7), que le circuit amortisseur (2) est situé entre cet oscillateur et la sortie du circuit à multivibrateurs monostables (6), et que le circuit d'évaluation (3) est raccordé par l'intermédiaire d'un réseau (8) à la liaison présente entre le circuit intégré (5) et le circuit à multivibrateurs monostables (6).

2. Interrupteur de proximité suivant la revendication 1, caractérisé par le fait que le circuit d'évaluation (3) comporte deux bornes qui sont raccordées à deux sorties du réseau (8) du circuit de contrôle (1), la première borne (E) étant raccordée à une charge (9) et la seconde borne au pôle négatif d'une tension continue qui est produite par un bloc d'alimentation secteur (14) et alimente le circuit d'évaluation (30).

3. Interrupteur de proximité suivant la revendication 2, caractérisé par le fait qu'en aval de la charge (9) sont branchés, selon la séquence indiquée, un déclencheur de Schmitt (10), un circuit (11) de protection contre les courts-circuits, un circuit amplificateur (12), un transformateur (Tr) et le circuit de relais (13), ce dernier étant raccordé par l'intermédiaire d'une sortie du circuit d'évaluation à un circuit de charge (15) qui doit être commandé par l'interrupteur de proximité.

4. Interrupteur de proximité suivant la revendication 3, caractérisé par le fait que le circuit de relais (13) possède un circuit en pont redresseur (V10) possédant un pôle positif et un pôle négatif et qui est raccordé, par son entrée, au côté secondaire du transformateur (Tr) et au côté sortie duquel est raccordé, entre son pôle positif et son pôle négatif, un condensateur de lissage (C2), en parallèle avec lequel est branché un circuit série formé par un condensateur (C3), une première résistance ohmique (R16) ainsi que deux contacts d'ouverture (17,18) de deux relais (K1,K2) à commande forcée, qui possèdent également deux contacts de fermeture (19,20), qu'en parallèle avec le condensateur (C3) sont branchés une seconde résistance ohmique (R15) ainsi qu'un circuit série formé d'une diode Zener (V11) et une troisième résistance ohmique (R17), que la cathode de la diode Zener (V11) est raccordée au pôle positif et que le point de jonction entre la diode Zener (V11) et la troisième résistance ohmique (R17) est raccordé à l'électrode de commande d'un thyristor (V12), dont la cathode est raccordée, de même que la troisième résistance ohmique (R17), à la borne, située à l'opposé du pôle positif, du condensateur (C3), et entre le pôle positif et l'anode du thyristor (V12) sont branchés en série les deux relais (K1,K2), en parallèle avec lesquels est disposée une diode (V13), qui est raccordée par sa cathode au pôle positif, que les deux contacts de fermeture (19,20) branchés en série sont disposés entre l'anode de cette diode et le pôle négatif et que deux autres contacts de fermeture (21,22) commutés par les relais (K1,K2) sont disposés dans le circuit de charge (15).

EP 0 308 766 B1

FIG 1

FIG 2

FIG 3

EP 0 308 766 B1